# EUROPEAN PATENT APPLICATION

(11) **EP 2 790 325 A1**
(43) Date of publication of application: **15.10.2014**
(21) Application number: 13305470.0
(22) Date of filing: 11.04.2013
(51) Int. Cl.: H03L 7/099, H03B 1/00

(54) **Voltage-controlled oscillator circuit and phase-locked loop device comprising the same**

(71) Applicant: Asahi Kasei Microdevices Corporation, Tokyo 101-8101 (JP)
(72) Inventor: Lecuyer, Matthieu, 14460 Colombelles (FR)
(74) Representative: Cabinet Plasseraud

(57) **Abstract**

A voltage-controlled oscillator (VCO) circuit (100) comprises a capacitor module (1), an inductor module (2), two common-base transistors (3, 4) and two feedback connections (6, 7) extending respectively from intermediate nodes (I, J) of the inductor module to main terminals (32, 42) of the common-base transistors. The feedback connections comprise buffer transistors (60, 70) for reducing feedback currents which are extracted from the inductor module. The VCO circuit exhibits low phase noise and leads to short lock time when included into a phase-locked loop.

## Description

The invention relates to a voltage-controlled oscillator (VCO) circuit, and a phase-locked loop (PLL) device which comprises such VCO circuit.

### -- BACKGROUND OF THE INVENTION --

There is still a need for voltage-controlled oscillators which exhibit improved performances, in particular when included in PLL devices. The performances required include some of the followings ones:
- the phase of the signal produced by the PLL device should exhibit low jitter, with low in-band and out-band noise;
- the lock time of the PLL device should be short, preferably less than 20 µs (microsecond);
- the VCO circuit should preferably have a differential output for reducing noise in the outputted VCO signal;
- the VCO gain, denoted K_{VCO} and defined as the derivative of the frequency of the VCO signal which is outputted by the oscillator, with respect to an inputted direct voltage, should be low for reducing the phase noise and making it easier to integrate a loop filter within the PLL;
- the amplitude of the VCO signal should better be high;
- it should be possible to change very quickly the frequency of the VCO signal which is outputted by the oscillator, thereafter denoted VCO frequency, without significantly modifying the amplitude and the phase of the VCO signal; and
- the structure of the VCO circuit should be compatible with in-chip integration.

Numerous VCO circuits already exist, in particular of Hartley-type. Generally, a VCO circuit includes an energy tank comprised of a capacitor module and an inductor module, which are arranged so that energy is oscillation-transferred between the capacitor module and the inductor module, thereby producing the output VCO signal. The VCO circuit also comprises an active part which compensates for a damping of the oscillation, in particular for the oscillation damping which is due to energy losses occurring in the capacitor and inductor modules. In a Hartley-type VCO circuit, a feedback signal which is necessary for keeping the oscillation is extracted from the inductor module and re-injected into the active part of the VCO circuit. Document US 8,169,269 discloses such Hartley-type VCO circuit, with the active part comprised of two common-source transistors. But in such VCO circuit structure, transistor saturation limits the amplitude of the VCO signal due to the common-source operation of the transistors.

Therefore, an object of the present invention is to propose a novel VCO circuit which provides improved features for at least one of the performances listed above, or improved trade-off between several of them.

### -- SUMMARY OF THE INVENTION --

For meeting this object or others, a first aspect of the invention proposes a VCO circuit which is suitable for producing an output signal having a VCO frequency, and which comprises:
- a capacitor module, which has a voltage input adapted for tuning a capacitance value produced by the capacitor module between two nodes;
- an inductor module, which is connected in parallel with the capacitor module between both nodes and adapted for producing an inductance value for a current flowing between these nodes through the inductor module;
- two common-base transistors, each comprising a first main electrode, a second main electrode and a control electrode adapted for controlling a current flowing at the first main electrode of each common-base transistor separately, the first main electrodes of both common-base transistors being connected respectively to both nodes, and the control electrodes of both common-base transistors being connected to each other;

- two AC-insulating modules, which are connected respectively between the second main electrodes of both common-base transistors and a common reference terminal, and adapted for polarizing both common-base transistors while preventing that current at VCO frequency sinks into the common reference terminal; and
- two feedback connections each connecting separately an intermediate node of the inductor module to the second main electrode of one of the common-base transistors, each feedback connection comprising separately a buffer transistor which has itself a first main electrode, a second main electrode and a control electrode adapted for controlling a current flowing at the first main electrode of this buffer transistor. Within each feedback connection, the control electrode of the buffer transistor is connected to the corresponding intermediate node of the inductor module, the first main electrode of the same buffer transistor is connected to a voltage reference terminal, and the second main electrode of this buffer transistor is connected to the second main electrode of the corresponding common-base transistor.

In such VCO circuit of the invention, a voltage which exists between both nodes forms the output signal having the VCO frequency. Thus the VCO circuit has a differential output, thereby leading to reduced noise in the VCO signal outputted.

Additionally, the transistors of the active part of the invention VCO circuit operate in common-base mode. Thanks to this transistor operation mode, the voltages existing at the first and second main electrodes of each transistor of the active part vary simultaneously with almost same time-rate. Thus, transistor saturation is reached for greater voltage variations, so that the amplitude of the VCO signal can be higher, thereby participating to further reducing noise sensitivity of the VCO signal.

The invention VCO circuit is of Hartley-type because the feedback connections originate from within the inductor module.

The buffer transistors in the feedback connections compensate for the low input impedances of the second main electrodes of the common-base transistors. Indeed, a feedback current at VCO frequency which is driven by each feedback connection is limited in this way. This avoids extracting to much current from the inductor module, and avoids in turn that important feedback currents make worse the quality factor of the impedance module. The loop gain of the VCO circuit is thus maintained with good value.

Also, because the feedback connections including buffer transistors may be designed for producing a high coupling value between the inductor module and the active part of the VCO circuit, very rapid start of the oscillations is obtained for the VCO circuit.

Moreover, the invention VCO circuit is compatible with implementing a capacitor module which provides a low value for the VCO gain. Thus, phase noise in the PLL device is further reduced. In particular, the capacitor module may comprise at least one varactor based on diode or transistor components.

Preferably, the VCO circuit may be designed with a symmetric composition between the common reference terminal and a mid-point terminal of the inductor module. Then, this latter mid-point terminal of the inductor module is connected to the voltage reference terminal. Such symmetric composition improves common mode rejection and still further participates to noise reduction.

Possibly, the capacitor module may comprise at least one range selection branch which is connected between both nodes, this range selection branch comprising at least one capacitor setting a VCO frequency range. Then, the VCO frequency values which are contained in this range can be each produced for one voltage value applied to the voltage input of the capacitor module. When several such branches are provided in the capacitor module, for example in parallel with each other, then any one among several VCO frequency ranges can be selected upon switching one branch or another. In preferred implementations of the capacitor module, each range selection branch may comprise at least one capacitor and a branch switch connected in series, and also two charge-absorbing transistors which are connected respectively to both sides of the branch switch. These charge-absorbing transistors are controlled so as to absorb electric charges which are produced upon switching of the branch switch. Thus, the VCO frequency range can be switched without magnitude and phase loss in the VCO signal. Stabilization time of the VCO signal upon switching of the VCO frequency range can thus be shortened, and then the lock time in a PLL can be really improved.

Advantageously within at least one of the feedback connections, the control electrode of the buffer transistor may be connected to the corresponding intermediate node of the inductor module using a switchable capacitor bank. It is thus possible to switch capacitors within each feedback connection so as to tune the phase and magnitude of the feedback current which is re-injected into the common-base transistors. In this way, the phase noise can be optimized for each value and/or range of the VCO frequency. In particular embodiments of the invention, each switchable capacitor bank used in one of the feedback connections may comprise several selectable branches which are connected in parallel with each other, and each selectable branch comprises at least one capacitor and a branch switch which are connected in series.

In preferred embodiments of the invention, the VCO circuit may further comprise:
- a voltage regulator, which is adapted for supplying a reference voltage, and has a first voltage supply terminal connected to the common reference terminal, and a second voltage supply terminal connected to the voltage reference terminal;
- a current source; and
- a mirror-controlling transistor which comprises a first main electrode, a second main electrode and a control electrode adapted for controlling a current flowing at the first main electrode of this mirror-controlling transistor, with the first main electrode of the mirror-controlling transistor which is connected to an output of the current source, the second main electrode of the mirror-controlling transistor connected to the common reference terminal, and the control electrode of the mirror-controlling transistor which is connected to its first main electrode and also connected to the control electrode of each one of the common-base transistors and buffer transistors, so that polarizing currents which flow at the respective first main electrodes of the common-base transistors and buffer transistors all reflect a current value which is produced by the current source.

Thus, tuning the voltage regulator is one of the elements which act on the amplitude of the VCO signal outputted, and separately tuning the current source allows selecting properly the operation point of all the common-base transistors and buffer transistors. It is thus possible to tune the loop coupling coefficient of the VCO circuit so as to optimize quality of the VCO signal outputted, and also optimizing the VCO signal amplitude.

Possibly, the control electrode of the mirror-controlling transistor may be connected to its first main electrode using a base-compensation transistor.

In various embodiments of the invention, the common-base transistors and buffer transistors may be all of one and same type selected among NPN-bipolar transistors, PNP-bipolar transistors, N-MOSFET transistors and P-MOSFET transistors.

Practically, at least the capacitor module, the inductor module, both common-base transistors and both feedback connections may be integrated within one or more circuit chips. Most preferably, the AC-insulating modules may also be integrated within the circuit chips. Low-cost and efficient VCO circuits can thus be produced.

A second aspect of the invention proposes a PLL device which comprises a VCO circuit according to the first invention aspect.

These and other features of the invention will be now described with reference to the appended figures, which relate to preferred but not-limiting embodiments of the invention.

### -- BRIEF DESCRIPTION OF THE DRAWINGS --

Figure 1 is an electric diagram of the AC-component of a VCO circuit according to the invention;
Figure 2 is an electric diagram of a capacitor module possibly used in a VCO circuit according to Figure 1;
Figure 3 is electric diagram of capacitor banks possibly used in feedback connections of a VCO circuit according to Figure 1;
Figure 4 is an electric diagram of a polarization component of a VCO circuit according to Figure 1; and
Figure 5 is a block diagram of a PLL device according to the invention.

Same reference numbers which are indicated in different ones of these figures denote identical elements of elements with identical function. In addition, components with well-known functions and operation but not connected directly to the invention features are not described in detail.

### -- DETAILED DESCRIPTION OF THE INVENTION --

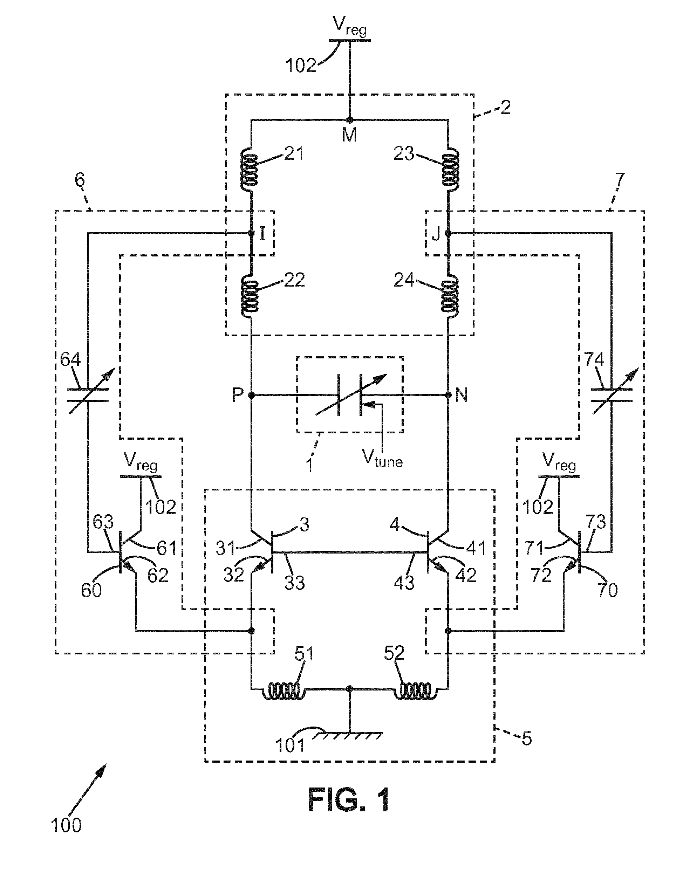

According to Figure 1, a VCO circuit denoted 100 as a whole comprises a capacitor module 1, an inductor module 2 and an active part 5 which are connected in parallel with each other between two nodes P and N. The output VCO signal is an AC-component of the voltage existing between both nodes P and N. For taking advantage of the common mode rejection, the VCO circuit 100 is preferably symmetric in composition between a common reference terminal 101 and a voltage reference terminal 102 with voltage reference value denoted V_{reg}.

The inductor module 2 may be comprised of two branches extending respectively between a mid-point terminal M and the node P, and between the terminal M and the node N. Terminal M is connected to the voltage reference terminal 102. The branch between terminal M and node P comprises the inductors 21 and 22 in series, and the branch between terminal M and node N comprises the inductors 23 and 24 also in series. The inductors 21 and 23 may be both equal to 600 pH (picoHenry), and the inductors 22 and 24 may be both equal to 260 pH, for example. I denotes a node intermediate between the inductors 21 and 22, and J denotes a node intermediate between the inductors 23 and 24.

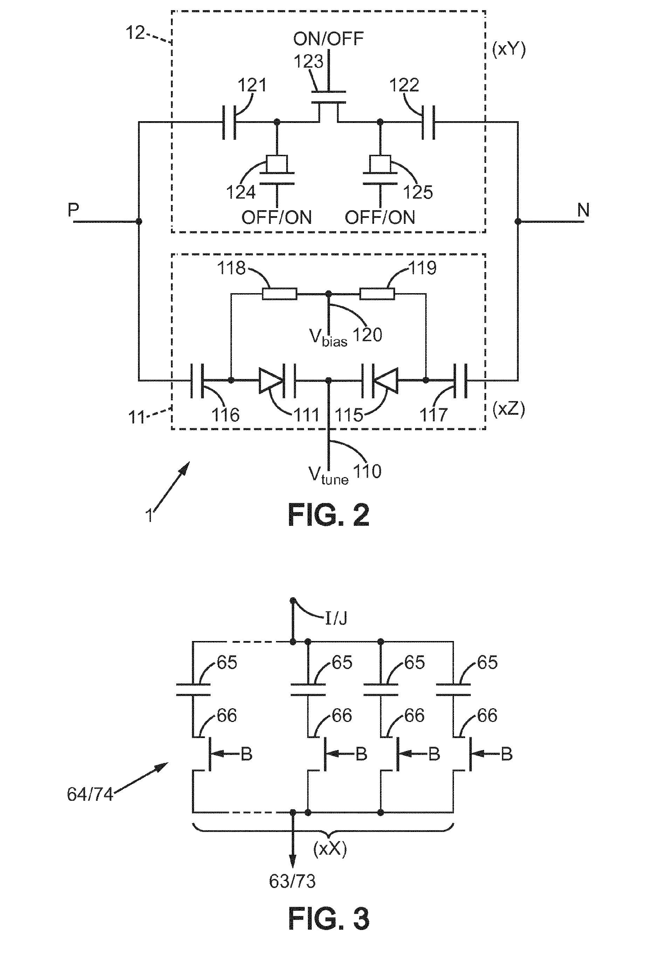

Figure 2 illustrates a possible embodiment for the capacitor module 1. The capacitor module 1 may be comprised of Z selectable varactor branches 11 and Y selectable capacitor branches 12, Z and Y being integers.

Each varactor branch 11 may itself be comprised of two branch segments which connect a voltage input 110 respectively to the nodes P and N. Reference numbers 111 and 115 denote varactors in each branch segment, which may be based in a usual manner on diode or FET-transistor components. Varactors 111 and 115 are preferably identical. Reference numbers 116 and 117 denote coupling capacitors also preferably identical and serially connected with the varactors 111 and 115, and reference numbers 118 and 119 denote bias resistors, again preferably identical. Each bias resistor 118, 119 connect a node intermediate between the coupling capacitor and the varactor within each branch segment, to a bias voltage input 120. Due to the varactor operation, the overall capacitance value of each varactor branch 11 changes upon varying the value of the direct voltage Vₜᵤₙₑ which is applied at the input 110, with respect to the bias voltage V_{bias} which is applied at the input 120.

Each selectable capacitor branch 12 may be comprised of two capacitors 121 and 122 and a switch 123 connected in series within the branch. The switch 123 may be FET transistor-based, and two additional FET- transistors 124 and 125 may be arranged on both sides of the switch 123 so as to accept at least partially electrical charges which may be expelled from the source and the drain of the transistor-based switch 123 upon switching of this latter. Then, the transistors 124 and 125 are to be controlled in ON-state or OFF-state in opposition to the state of the switch 123. For example, the values of the capacitors 121 and 122 may be 250 fF (femtoFarad) in a first one of the selectable capacitor branches 12, and 40 fF in another selectable capacitor branch 12, and 10 fF in still another selectable capacitor branch 12 if three types of capacitor branches are implemented.

The frequency of the output VCO signal, namely the VCO frequency, depends on the inductance value of the inductor module 2 and the capacitance value of the capacitor module 1. Switching ON at least one of the capacitor branches 12 allows selecting a corresponding range for the VCO frequency, and varying the voltage Vₜᵤₙₑ then allows tuning the VCO frequency within this range. Because of this function, the branches 12 have been denoted range selection branches in the general part of the present description.

Back to Figure 1, the active part 5 of the VCO circuit 1 may be comprised of two transistors 3 and 4 connected in parallel, and preferably identical. For example, both transistors 3 and 4 may be NPN-bipolar transistors. Then, their collector terminals 31 and 41 are respectively connected to the nodes P and N, their respective base terminals 33 and 43 are connected to each other, and their emitter terminals 32 and 42 are connected to the common reference terminal 101 using inductors 51 and 52 respectively. The inductors 51 and 52 are selected so as to prevent currents varying at the VCO frequency from flowing from the emitter terminals of the transistors 3, 4, 60 and 70 to the common reference terminal 101, while ensuring that direct polarizing currents are driven by the inductors 51 and 52 to the same common reference terminal 101. Thus, the inductors 51 and 52 have the function of AC-insulating modules, but other implementations of this AC-insulating function may be used alternatively. Both transistors 3 and 4 are operating in common-base mode so that they have been denoted common-base transistors in the general part of this description.

Reference numbers 6 and 7 denote feedback connections of the VCO circuit 100. The feedback connection 6 connects the intermediate node I of the inductor module 2 to the emitter terminal 32 of the transistor 3. It may be comprised of a capacitor 64 which is serially connected to the base terminal 63 of a NPN-bipolar transistor 60. The emitter terminal 62 of this transistor 60 is then connected to the emitter terminal 32 of the transistor 3, and the collector terminal 61 of the transistor 60 is connected to the voltage reference terminal 102. Then, the impedance of the feedback connection 6 as existing from the intermediate node I is mostly determined by that of the base terminal 63 of the transistor 60. This limits the AC-feedback current which is extracted from the node I to much lower value as compared to connecting the node I to the emitter terminal 32 by only using the capacitor 64. For this reason, the transistors 60 and 70 have been denoted buffer transistors in the general part of this description.

Symmetrically, the feedback connection 7 connects the intermediate node J of the inductor module 2 to the emitter terminal 42 of the transistor 4. It may have a composition similar to that of the feedback connection 6. Thus, it may be comprised of a capacitor 74 which is serially connected to the base terminal 73 of a bipolar transistor 70. The emitter terminal 72 of this transistor 70 is connected to the emitter terminal 42 of the transistor 4, and the collector terminal 71 of the transistor 70 is connected to the voltage reference terminal 102.

Capacitors 64 and 74 may be similar to each other and adapted for being varied in capacitance value. To this purpose, each of them may have a structure of switchable capacitor bank as shown in Figure 3. It is comprised of X branches connected in parallel, X being an integer, with each branch comprising itself a unit capacitor 65 and a switch 66. Each switch 66 may be FET transistor-based, so that the corresponding branch is activated or disabled depending on a control bit B which is applied onto the control electrode of the switch 66. Hence, the capacitance value of both capacitors 64 and 74 can be controlled using a common digital word with each bit B applied onto two branch switches 66 pertaining respectively to the capacitors 64 and 74. In this way, both capacitors 64 and 74 are set to a same value at the same time. This capacitor value may be selected so that the phase and magnitude of the AC-feedback currents which are transferred from the emitter terminals 62 and 72 respectively to the emitter terminals 32 and 42 allow reducing the phase noise in the VCO signal. Such setting of the capacitors 64 and 74 depends on the VCO frequency range which is selected using the switches 123 of the capacitor module 1. For example, the unit capacitors 65 may each have a capacitance value of 500 fF.

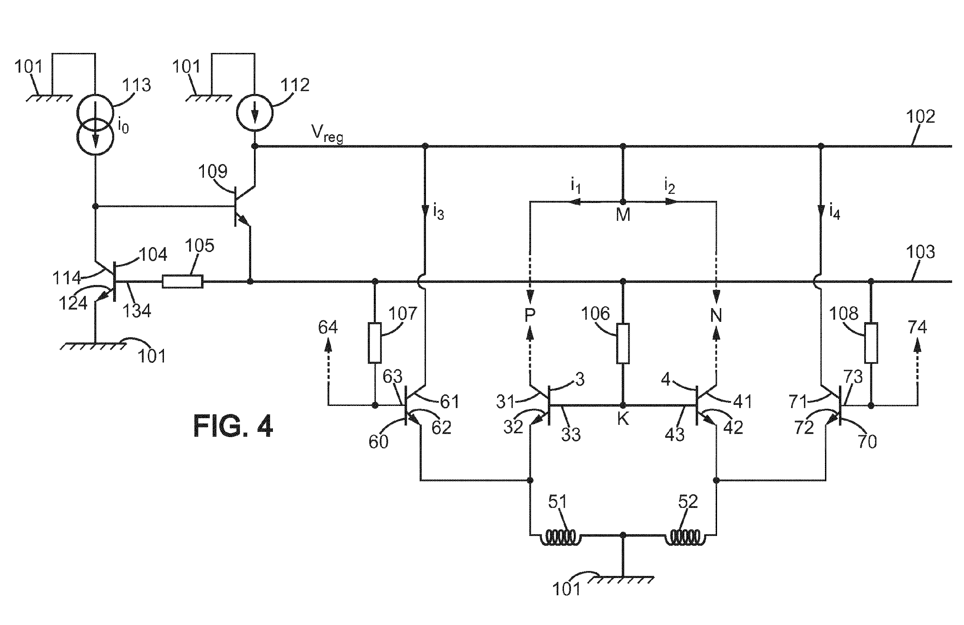

Figure 4 shows the polarization scheme of the VCO circuit 100. It comprises two conducting lines 102 and 103. The conducting line 102 corresponds to the voltage reference terminal already introduced with same reference number, and is voltage-supplied by a regulator 112 with the fixed voltage value V_{reg}. The respective collector terminals 61 and 71 of the transistors 60 and 70, and also the mid-point terminal M of the inductor module 2, are connected to the conducting line 102.

Reference number 113 denotes a current source with current value i₀, preferably of low-noise type. Transistor 104 form an entrance branch of a current-mirroring structure, which is common to current-mirroring output branches formed respectively by the transistors 3, 4, 60 and 70. To this purpose, the collector terminal 114 of the transistor 104 is connected to the output of the current source 113, its emitter terminal 124 is connected to the common reference terminal 101, and its base terminal is connected to the conducting line 103. Then, the respective base terminals 33, 43, 63 and 73 of the transistors 3, 4, 60 and 70 are also connected to the conducting line 103. Thus, DC-currents i₁ and i₂ which are inputted into the respective collector terminals 31 and 41 of the transistors 3 and 4, and DC-current i₃ which is inputted into the collector terminal 61 and also DC-current i₄ which is inputted into the collector terminal 71 are all controlled by setting the current value i₀. Reference numbers 105 to 108 denote resistors which may be 100 Ω (Ohm), 25 Ω, 200 Ω and 200 Ω. In this way, appropriate polarization is produced for the transistors 3, 4, 60 and 70.

Optionally, an additional transistor 109 may be implemented for base-compensating of the transistor 104.

Although the above-description refers to NPN-bipolar type for the transistors 3, 4, 60 and 70, it is obvious that PNP-bipolar transistors or MOSFET transistors, either N- or P-MOS type, could be used alternatively. Then, the phrase "common-base" applies for "common-gate" in the cases of MOSFET transistors, and the terminal names "collector", "emitter" and "base" are to be replaced with "drain", "source" and "gate". The polarization scheme is also to be adapted, but in an obvious manner for the Man skilled in electronics.

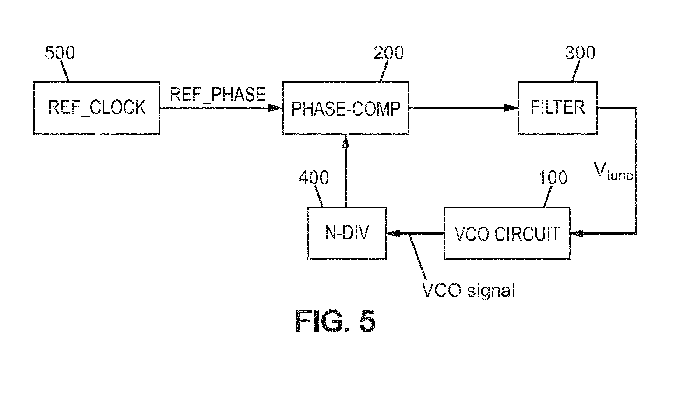

Figure 5 shows a phase-locked loop device incorporating the VCO circuit 100. The additional references in this figure have the following meanings:
- 200: phase comparison system denoted PHASE_COMP;
- 300: loop filter denoted FILTER;
- 400: frequency converter, which may be a N-divider or N-elevator, N being a division or multiplication factor greater than unity; and
- 500: reference clock denoted REF_CLOCK, which supplies a reference clock phase REF_PHASE.

In such PLL device, the frequency converter 400 decreases or increases the frequency of the VCO signal by the N-factor. The phase comparison system 200 produces a comparison signal which represents a difference between the reference clock phase and the phase of the signal delivered by the frequency converter 400. Then, the loop filter 300 operates a time-filtering onto the comparison signal for delivering the Vₜᵤₙₑ-voltage. And this latter is fed into the VCO circuit 100 at the voltage input 110. By using the invention VCO circuit 100, out-band noise is suppressed or decreased thanks to the performances of the VCO circuit itself, and in-band noise is suppressed or decreased thanks to the performances of the phase-locked loop.

## Claims

1. Voltage-controlled oscillator (VCO) circuit (100) suitable for producing an output signal having a VCO frequency, and comprising:
- a capacitor module (1) having a voltage input (110) adapted for tuning a capacitance value produced by the capacitor module between two nodes (P, N);
- an inductor module (2) connected in parallel with the capacitor module (1) between both nodes (P, N) and adapted for producing an inductance value for a current flowing between both nodes through the inductor module;
- two common-base transistors (3, 4) each comprising a first main electrode (31, 41), a second main electrode (32, 42) and a control electrode (33, 43) adapted for controlling a current flowing at the first main electrode of each common-base transistor separately, the first main electrodes of both common-base transistors being connected respectively to both nodes (P, N), and the control electrodes of said both common-base transistors being connected to each other;
- two AC-insulating modules (51, 52) connected respectively between the second main electrodes (32, 42) of both common-base transistors (3, 4) and a common reference terminal (101), and adapted for polarizing both common-base transistors while preventing that current at VCO frequency sinks into the common reference terminal; and
- two feedback connections (6, 7) each connecting separately an intermediate node (I, J) of the inductor module (2) to the second main electrode (32, 42) of one of the common-base transistors (3, 4), each feedback connection comprising separately a buffer transistor (60, 70) having a first main electrode (61, 71), a second main electrode (62, 72) and a control electrode (63, 73) adapted for controlling a current flowing at the first main electrode of said buffer transistor, and within each feedback connection the control electrode of the buffer transistor is connected to the corresponding intermediate node of the inductor module, the first main electrode of said buffer transistor is connected to a voltage reference terminal (102), and the second main electrode of said buffer transistor is connected to the second main electrode of the corresponding common-base transistor,
wherein a voltage existing between both nodes (P, N) forms the output signal having the VCO frequency.

2. VCO circuit according to Claim 1, designed with symmetric composition between the common reference terminal (101) and a mid-point terminal (M) of the inductor module (2), said mid-point terminal being connected to the voltage reference terminal (102).

3. VCO circuit according to Claim 1 or 2, wherein the capacitor module (1) comprises at least one varactor (111, 112) based on diode or transistor components.

4. VCO circuit according to any one of the preceding claims, wherein the capacitor module (1) comprises at least one range selection branch (12) connected between both nodes (P, N), said range selection branch comprising at least one capacitor (121, 122) setting a VCO frequency range, with VCO frequency values contained in said range being each produced for one voltage value applied to the voltage input (110) of the capacitor module (1).

5. VCO circuit according to Claim 4, wherein each range selection branch (12) comprises the at least one capacitor (121, 122) and a branch switch (123) connected in series, and also two charge-absorbing transistors (124, 125) connected respectively to both sides of the branch switch and controlled so as to absorb electric charges produced upon switching of said branch switch.

6. VCO circuit according to any one of the preceding claims wherein, within at least one of the feedback connections (6, 7), the control electrode (63, 73) of the buffer transistor (60, 70) is connected to the corresponding intermediate node (I, J) of the inductor module (2) using a switchable capacitor bank (64, 74).

7. VCO circuit according to Claim 6, wherein each switchable capacitor bank (64, 74) comprises several selectable branches connected in parallel with each other, each selectable branch comprising at least one capacitor (65) and a branch switch (66) connected in series.

8. VCO circuit according to any one of the preceding claims, further comprising:
- a voltage regulator (112) adapted for supplying a reference voltage, and having first voltage supply terminal connected to the common reference terminal (101) and second voltage supply terminal connected to the voltage reference terminal (102);
- a current source (113); and
- a mirror-controlling transistor (104) comprising a first main electrode (114), a second main electrode (124) and a control electrode (134) adapted for controlling a current flowing at the first main electrode of said mirror-controlling transistor, with the first main electrode of said mirror-controlling transistor connected to an output of the current source (113), the second main electrode of said mirror-controlling transistor connected to the common reference terminal (101), and the control electrode of said mirror-controlling transistor connected to the first main electrode of said mirror-controlling transistor and also connected to the control electrode (33, 43, 63, 73) of each one of the common-base transistors (3, 4) and buffer transistors (6, 7), so that polarizing currents flowing at the first main electrodes of said common-base transistors and buffer transistors all reflect a current value produced by the current source.

9. VCO circuit according to Claim 8, wherein the control electrode (134) of the mirror-controlling transistor (104) is connected to the first main electrode (114) of said mirror-controlling transistor using a base-compensation transistor (109).

10. VCO circuit according to any one of the preceding claims, wherein the common-base transistors (3, 4) and buffer transistors (60, 70) are all of one and same type selected among NPN-bipolar transistors, PNP-bipolar transistors, N-MOSFET transistors and P-MOSFET transistors.

11. VCO circuit according to any one of the preceding claims, wherein at least the capacitor module (1), the inductor module (2), both common-base transistors (3, 4) and both feedback connections (6, 7) are integrated within one or more circuit chips.

12. Phase-locked loop (PLL) device comprising a VCO circuit (100) according to any one of the preceding claims.
